# EUROPÄISCHE PATENTSCHRIFT

(11) **EP 1 072 744 B1**
(45) Veröffentlichungstag und Bekanntmachung des Hinweises auf die Patenterteilung: **07.04.2004**
(21) Anmeldenummer: 00116390.6
(22) Anmeldetag: 28.07.2000
(51) Int. Cl.: E05C 3/14, G11B 33/02, H05K 5/02

(54) **Gehäuseteil mit einem daran angeordneten Rastelement**
Casing part comprising a rest element
Partie de boîtier pourvue d' un élément d' arrêt

(30) Priorität: 30.07.1999 DE 19935897
(43) Veröffentlichungstag der Anmeldung: 31.01.2001
(73) Patentinhaber: ROBERT BOSCH GMBH, 70442 Stuttgart (DE)
(72) Erfinder: Buehren, Rainer, 38239 Salzgitter (DE)

(56) Entgegenhaltungen:
- EP-A- 0 883 127
- DE-A- 3 702 118
- DE-U- 29 821 107
- US-A- 3 797 870

## Beschreibung

### Stand der Technik

Die Erfindung betrifft ein Gehäuseteil mit einem daran angeordneten Rastelement mit den im Oberbegriff des unabhängigen Anspruchs 1 angegebenen Merkmalen.

Ein derartiges Gehäuseteil ist beispielsweise aus der DE 197 23 952 A1 bekannt. Das dort gezeigte Gehäuse eines Abspielgerätes für Aufzeichnungsträger weist an seiner Frontseite ein Rastelement aufweist, das mit einem Rasthaken von der Frontwand des Gehäuses absteht, welcher um eine parallel zu der Frontwand verlaufende Achse entgegen der Spannkraft eines Federelementes schwenkbar ist. Das Federelement wird durch eine über das Schwenkgelenk geschobene Schenkelfeder gebildet, die sich mit einem Ende an dem Rasthaken und mit dem anderen Ende an der Frontseite des Gehäuses abstützt. Derartige Rastelemente dienen beispielsweise zur Arretierung einer vor die Frontwand schwenkbaren Geräteklappe. Durch Betätigung einer in die Geräteklappe integrierten und auf den Rasthaken einwirkenden Drucktaste wird das Rastelement entgegen der Spannkraft des Federelementes bei gleichzeitiger Freigabe der Geräteklappe um seine Drehachse geschwenkt. Nachteilig bei den bekannten Anordnungen ist, daß die Montage des Rastelementes mit dem Federelement relativ aufwendig ist, da das Federelement unabhängig von dem Rastelement gefertigt werden muß und das Rastelement zusammen mit dem Federelement vom Gehäuseinnenraum aus an dem Gehäuseteil festgelegt wird. Das Federelement und das Rastelement müssen in ihren Dimensionierungen und Lage sorgfältig aufeinander abgestimmt sein, um eine einwandfreie Funktion zu gewährleisten. Ein nachträglicher Einbau des Rastelementes von außerhalb des Gehäuses ist nicht möglich.

Darüber hinaus sind feststehende Rasthaken aus der US 3,797,870 bekannt, die einen elastisch biegsamen von dem Gehäuseteil abstehenden Grundkörper aufweisen dessen Ende hakenförmig ausgebildet ist. Ein Schwenkgelenk ist nicht erforderlich, da der Rasthaken zur Freigabe einer schwenkbaren Frontklappe durch ein auf den Rasthaken einwirkendes Betätigungselement gebogen wird. Derartige Rasthaken neigen jedoch zur Materialermüdung, so daß der Rasthaken nach einiger Zeit nicht mehr hinter dem dafür vorgesehenen Vorsprung der Klappe einrastet und die Klappe nicht mehr zuverlässig schließt.

### Vorteile der Erfindung

Durch das erfindungsgemäße Gehäuseteil mit dem daran angeordneten Rastelement werden die beim Stand der Technik auftretenden Nachteile vermieden. Das Rastelement ist vorteilhaft von außen aus durch eine Ausnehmung einer Gehäusewand an dem Gehäuseteil zu montieren. Dies kann mit wenigen einfachen Handgriffen erfolgen. Ein Öffnen des Gehäuseteils ist hierfür nicht erforderlich. Das Rastelement wird lediglich mit wenigstens einem Lagerzapfen durch eine dafür vorgesehene Ausnehmung in eine an dem Gehäuseteil ausgebildete Lagerpfanne eingeschoben und durch eine anschließende Schwenkbewegung quasi in die Ausnehmung eingeklipst. Der Rasthaken, welcher von der Gehäusewand nach außen absteht, dient dabei vorteilhaft als eine Handhabe. Weiterhin ist vorteilhaft, daß das Federelement direkt an dem Rastelement ausgebildet ist, so daß nur ein Teil montiert werden muß. Besonders vorteilhaft ist, daß das Rastelement zusammen mit dem Federelement preiswert aus Kunststoff gefertigt werden kann.

### Zeichnungen

Ein Ausführungsbeispiel der Erfindung wird in der Zeichnung dargestellt und ist in der nachfolgenden Beschreibung näher erläutert. Es zeigt
Fig. 1 ein Rastelement während der Festlegung an dem Gehäuseteil im Querschnitt,
Fig. 2 das Rastelement nach der Festlegung an dem Gehäuseteil,
Fig. 3 das Rastelement in einer geschwenkten Position, in der beispielsweise eine zuvor an dem Gehäuseteil festgelegte Klappe von dem Rasthaken freigegeben wird.

### Beschreibung eines Ausführungsbeispiels

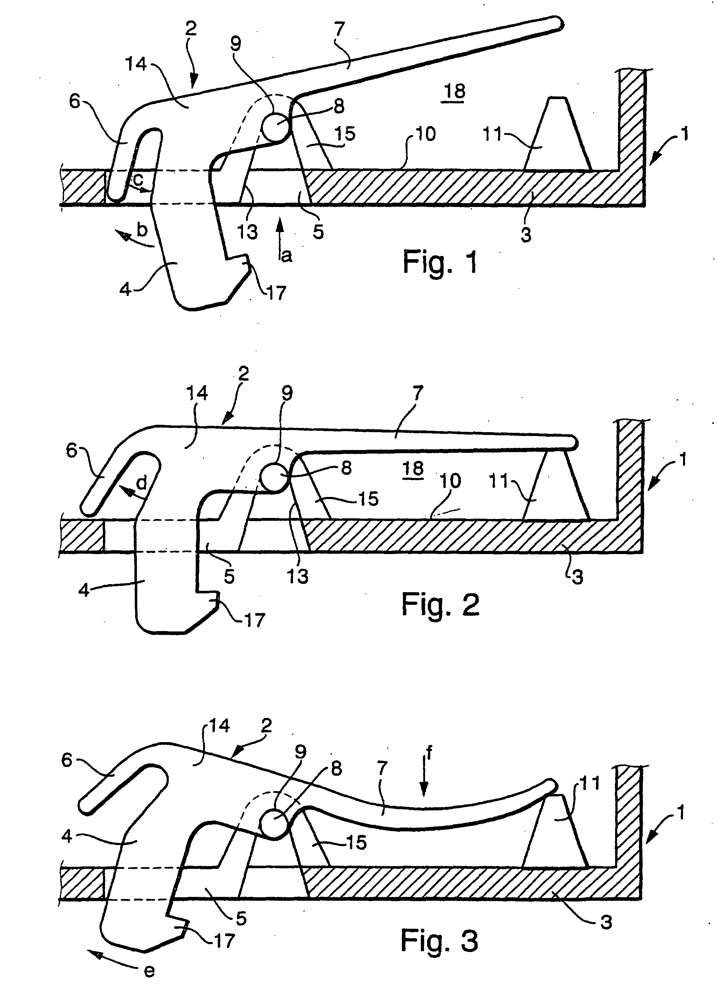

Fig. 1 zeigt im Querschnitt eine Teilansicht eines Gehäuseteils, beispielsweise des Gehäuses eines Autoradiogerätes. Das Gehäuse 1 umgibt einen Gehäuseinnenraum 18 der durch eine Ausnehmung 5 in einer Gehäusewand 3 mit dem Außenraum verbunden ist. Die Gehäusewand 3 ist in diesem Beispiel die Vorderwand des Radiogerätes. Eine nicht dargestellte Frontklappe kann vor die Vorderwand 3 geschwenkt werden, wobei ein Rastelement 2 vorgesehen ist, welches die Frontklappe in der geschlossenen Position an der Vorderwand 3 des Gehäuseteils 1 arretiert. Fig. 1 zeigt die Montage dieses Rastelementes an dem Gehäuseteil. Die Ausnehmung 5 weist an zwei sich gegenüberliegenden Innenwänden, von denen in der Querschnittsdarstellung von Fig. 1 nur eine erkennbar ist, jeweils eine im wesentlichen U- oder V-förmige Führungsnut 13 auf, deren offenes Ende dem Außenraum zugewandt ist und deren geschlossenes Ende in dem Gehäuseinnenraum 18 angeordnet ist und ein Lager 9 für einen Lagerzapfen 8 des Rastelementes 2 bildet. Die Führungsnut 13 ist an der Innenwandung der Ausnehmung 5 und einem Vorsprung 15 angeordnet, welcher auf der dem Gehäuseinnenraum 18 zugewandten Seite 10 von der Gehäusewand 3 absteht.

Das Rastelement 2 ist als Formteil aus Kunststoff gefertigt, vorzugsweise aus Poly-Oxymethylen (POM) oder einem anderen elastisch biegsamen Kunststoff und weist einen im wesentlichen quaderförmigen Grundkörper 14 auf, von dem an sich gegenüberliegenden Seitenwänden zwei Lagerzapfen 8 senkrecht abstehen, die koaxial zueinander angeordnet sind. Von dem Grundkörper 14 steht ein mit einer Rastnase 17 versehener Rasthaken 4 senkrecht zu den beiden Lagerzapfen 8 ab. An dem Grundkörper 14 ist weiterhin eine elastisch biegsame Zunge 6 ausgebildet, die ausgehend von der von dem Rasthaken 4 abgewandten Seite des Grundkörpers 14 derart gebogen ist, daß ihr freies Ende leicht schräg zu dem Rasthaken 4 von dem Grundkörper 14 absteht. An dem der Zunge 6 gegenüberliegenden Ende des Rastelementes 2 steht ein elastisch biegsames schenkelförmiges Federelement 7 senkrecht zu dem Rasthaken 4 und senkrecht zu den beiden Lagerzapfen 8 von dem Grundkörper 14 ab. Das Federelement 7 kann aber auch in einem anderen Winkel von dem Grundkörper abstehen. Das Federelement 7 weist eine Materialstärke auf, die ausreichend gering ist, um eine elastische Biegsamkeit des Federelementes 7 zu erreichen, und hat quasi die Funktion einer Blattfeder, welche eine federelastische Auslenkung des Rastelementes 2 ermöglicht.

Bei der Montage wird zunächst das Rastelement mit dem als Federelement vorgesehenen Schenkel 7 von außerhalb des Gehäuses 1 durch die Ausnehmung 5 in den Geräteinnenraum eingeführt und die beiden Lagerzapfen 8 in die Führungsnuten 13 in Richtung des Pfeils a in Fig. 1 eingeschoben, bis sich die Lagerzapfen 8 in den Lagerpfannen 9 befinden. Die trichterförmigen Führungsnuten 13 erleichtern hierbei das Einschieben. Anschließend wird das Rastelement 4 um die Lagerzapfen 8 in Richtung des Pfeils b zur Gehäusewand 3 geschwenkt. Der durch die Ausnehmung 5 nach außen abstehende Rasthaken 4 bildet hierbei eine Handhabe zum Halten und Schwenken des Rastelementes. Durch die Schwenkbewegung wird die elastisch biegsame Zunge 6 gegen den Rand der Ausnehmung 5 gedrückt und federt in Richtung des Pfeils c in Fig. 1 zurück. Durch weiteres Schwenken in Richtung des Pfeils b gelangt das Rastelement 2 in die in Fig. 2 gezeigte Position. Die elastisch biegsame Zunge 6 spreizt hinter dem Rand der Ausnehmung 5 in Richtung des Pfeils d auf hinterfaßt widerhakenartig den Rand der Ausnehmung 5 auf der dem Gehäuseinnenraum 18 zugewandten Seite 10 der Gehäusewand 3. Etwa zum gleichen Zeitpunkt der Schwenkbewegung gelangt das Federelement 7 an einem Anschlag 11 an der Innenseite 10 der Gehäusewand zur Anlage. Die Dimensionen des Federelementes 7 und der Zunge 6 können so aufeinander abgestimmt sein, daß das Federelement 7 an dem Anschlag 11 zur Anlage gelangt, bevor die Zunge 6 hinter dem Rand der Ausnehmung 5 aufspreizt. In diesem Fall wird das Rastelement 2 gegen die Spannkraft des Federelementes 2 noch etwas in Richtung des Pfeiles b geschwenkt, bis die Zunge 6 hinter der Ausnehmung verrastet. Hierdurch wird erreicht, daß die Zunge 6 durch die Spannkraft des Federelementes 7 gegen die Innenseite 10 der Gehäusewand vorgespannt wird. Klappergeräusche können so vermieden werden.

Fig. 3 zeigt das Rastelement 2 in einem Zustand, in dem die schwenkbare Frontklappe freigegeben wird. Zu diesem Zweck ist eine nicht dargestellte Drucktaste in der Frontklappe eingebaut, welche bei einer Betätigung den Rasthaken 4 in Richtung des Pfeils e schwenkt, wodurch die hinter einem Vorsprung der nicht dargestellten Frontklappe verrastete Rastnase 17 die Frontklappe freigibt. Beim Schwenken des Rastelements 2 um die Lagerzapfen 8 wird das von dem Grundkörper 14 abstehende Ende des Federelementes 7 gegen des Vorsprung 11 derart angedrückt, daß sich das elastisch biegsame Federelement in Richtung des Pfeils f verbiegt. Das Rastelement 2 ist nun gegen den Anschlag 11 vorgespannt und bewegt sich nach Loslassen der auf den Rasthaken einwirkenden Drucktaste in die in Fig. 2 gezeigte Position zurück.

## Patentansprüche

1. Gehäuseteil mit einem daran angeordneten Rastelement (2), welches einen von einer Gehäusewand (3) des Gehäuseteils (1) nach außen abstehenden Rasthaken (4) aufweist, der entgegen der Spannkraft eines Federelementes (7) um eine parallel zu der Gehäusewand (3) verlaufende Achse schwenkbar ist, **dadurch gekennzeichnet, daß** das Rastelement (2) mit wenigstens einem Lagerzapfen (8) von außerhalb des Gehäuseteils (1) durch eine Ausnehmung (5) der Gehäusewand (3) in wenigstens eine Lagerpfanne (9) des Gehäuseteils (1) eingesetzt ist, wobei eine an dem Rastelement (2) ausgebildete, elastisch biegsame Zunge (6) an der dem Gehäuseinnenraum (18) zugewandten Seite (10) der Gehäusewand (3) den Rand der Ausnehmung (5) widerhakenartig hinterfaßt und sich ein an dem Rastelement ausgebildetes, der Zunge (6) in bezug auf den Lagerzapfen (8) gegenüberliegendes elastisch biegsames Federelement (7) an einem an der Innenseite (10) der Gehäusewand (3) ausgebildeten Anschlag (11) abstützt.

2. Gehäuseteil nach Anspruch 1, **dadurch gekennzeichnet, daß** der von der Gehäusewand (3) abstehende Rasthaken (4) eine Handhabung zur Montage des Rastelementes (2) an dem Gehäuseteil (1) bildet.

3. Gehäuseteil nach Anspruch 1, **dadurch gekennzeichnet, daß** sich die widerhakenartig aufgespreizte Zunge (6) an der Innenseite (10) der Gehäusewand (3) abstützt und durch die Spannkraft des an dem Anschlag (11) anliegenden elastisch biegsamen Federelementes (7) gegen die Gehäusewand vorgespannt wird.

4. Gehäuseteil nach Anspruch 1, **dadurch gekennzeichnet, daß** der wenigstens eine Lagerzapfen (8) senkrecht zu dem Rasthaken (4) und senkrecht zu dem elastisch biegsamen Federelement (7) von dem Rastelement (2) absteht.

5. Gehäuseteil nach Anspruch 4, **dadurch gekennzeichnet, daß** die Schwenkachse durch zwei koaxial angeordnete und an sich gegenüberliegenden Abschnitten des Rastelementes (2) von diesem abstehende Lagerzapfen (8) gebildet wird.

6. Gehäuseteil nach Anspruch 5, **dadurch gekennzeichnet, daß** an zwei sich gegenüberliegenden Abschnitten der Innenwandung der Ausnehmung (5) im wesentlichen U-förmige oder V-förmige Führungsnuten (13) angeordnet sind, deren dem Innenraum (18) des Gehäuseteils (1) zugewandten geschlossenen Enden zwei Lagerpfannen (9) zur Aufnahme der Lagerzapfen (8) bilden.

7. Gehäuseteil nach Anspruch 1, **dadurch gekennzeichnet, daß** das elastisch biegsame Federelement (7) durch einen von dem Rastelement abstehenden dünnwandigen Schenkel gebildet wird.

8. Gehäuseteil nach einem der vorstehenden Ansprüche, **dadurch gekennzeichnet, daß** das Rastelement (2) mit dem Rasthaken (4), der elastisch biegsamen Zunge (6), dem elastisch biegsamen Federarm (7) und dem wenigstens einen Lagerzapfen (8) einstückig aus Kunststoff gefertigt ist.

9. Gehäuseteil nach Anspruch 8, **dadurch gekennzeichnet, daß** der Kunststoff Poly-Oxymethylen (POM) ist.

## Claims

1. Housing part having a latching element (2) arranged on it, the said latching element having a latching hook (4) which projects outwards from a housing wall (3) of the housing part (1) and is pivotable, counter to the tensioning force of a spring element (7), about an axis running parallel to the housing wall (3), **characterized in that** the latching element (2) is inserted with at least one bearing journal (8), from outside the housing part (1), through a recess (5) of the housing wall (3) into at least one bearing socket (9) of the housing part (1), an elastically flexible tongue (6) formed on the latching element (2) catching behind the edge of the recess (5) in a barb-like manner on that side (10) of the housing wall (3) which faces the housing interior (18), and an elastically flexible spring element (7) formed on the latching element and located opposite the tongue (6) with respect to the bearing journal (8) being supported on an abutment (11) formed on the inside (10) of the housing wall (3).

2. Housing part according to Claim 1, **characterized in that** the latching hook (4) projecting from the housing wall (3) forms a handle for mounting the latching element (2) on the housing part (1).

3. Housing part according to Claim 1, **characterized in that** the tongue (6) spread open in a barb-like manner is supported on the inside (10) of the housing wall (3) and is pretensioned against the housing wall by the tensioning force of the elastically flexible spring element (7) bearing on the abutment (11).

4. Housing part according to Claim 1, **characterized in that** the at least one bearing journal (8) projects from the latching element (2) perpendicularly to the latching hook (4) and perpendicularly to the elastically flexible spring element (7).

5. Housing part according to Claim 4, **characterized in that** the pivot axis is formed by two coaxially arranged bearing journals (8) projecting from the latching element (2) on portions of the latter which are located opposite one another.

6. Housing part according to Claim 5, **characterized in that** portions of the inner wall of the recess (5) which are located opposite one another have arranged on them essentially U-shaped or V-shaped guide grooves (13), of which the closed ends facing the interior (18) of the housing part (1) form two bearing sockets (9) for receiving the bearing journals (8).

7. Housing part according to Claim 1, **characterized in that** the elastically flexible spring element (7) is formed by a thin-walled leg projecting from the latching element.

8. Housing part according to one of the preceding claims, **characterized in that** the latching element (2) is manufactured from plastic in one piece with the latching hook (4), the elastically flexible tongue (6), the elastically flexible spring arm (7) and the at least one bearing journal (8).

9. Housing part according to Claim 8, **characterized in that** the plastic is polyoxymethylene (POM).

## Revendications

1. Partie de boîtier pourvue d'un élément d'accrochage (2), qui présente un crochet d'accrochage (4) s'écartant vers l'extérieur d'une paroi de boîtier (3) de la partie de boîtier (1) et pouvant pivoter autour d'un axe s'étendant parallèlement à la paroi de boîtier (3) à l'encontre de la force de tension élastique d'un élément ressort (7),
**caractérisée en ce que**
l'élément d'accrochage (2) est introduit avec au moins un tourillon (8) dans au moins un coussinet (9) de la partie de boîtier (1) à partir de l'extérieur de la partie de boîtier (1) à travers une découpe (5) de la paroi de boîtier (3), avec une languette (6) souple élastique formée au niveau de l'élément d'accrochage (2) qui à la façon d'un crochet passe derrière la découpe (5) au niveau du côté (10) de la paroi de boîtier (3) tourné vers l'intérieur du boîtier (18), et avec un élément ressort (7) élastique opposé à la languette (6) par rapport au tourillon (8) et formé sur l'élément d'accrochage qui s'appuie contre une butée (11) formée sur le côté intérieur (10) de la paroi de boîtier (3).

2. Partie de boîtier selon la revendication 1,
**caractérisée en ce que**
le crochet d'accrochage (4) s'écartant de la paroi de boîtier (3) constitue un élément de commande pour le montage de l'élément d'accrochage (2) sur la partie de boîtier (1).

3. Partie de boîtier selon la revendication 1,
**caractérisée en ce que**
la languette (6) déployée à la façon d'un crochet s'appuie contre le côté intérieur (10) de la paroi de boîtier (3) et est précontrainte contre la paroi de boîtier par la force de tension élastique de l'élément ressort (7) élastique reposant sur la butée (11).

4. Partie de boîtier selon la revendication 1,
**caractérisée en ce qu'**
au moins un tourillon (8) s'écarte de l'élément d'accrochage (2) perpendiculairement au crochet d'accrochage (4) et perpendiculairement à l'élément ressort (7) élastique.

5. Partie de boîtier selon la revendication 4,
**caractérisée en ce que**
l'axe de pivotement est formé de deux tourillons (8) disposés de façon coaxiale et s'écartant de l'élément d'accrochage (2) au niveau de deux parties de celui-ci situées face à face.

6. Partie de boîtier selon la revendication 5,
**caractérisée en ce que**
des rainures de guidage (13) pour l'essentiel en forme de U ou en forme de V sont disposées sur deux parties situées face à face de la paroi intérieure de la découpe (5), les extrémités fermées et tournées vers l'espace intérieur (18) de la partie de boîtier (1) de ces rainures de guidage formant deux coussinets (9) destinés à recevoir les tourillons (8).

7. Partie de boîtier selon la revendication 1,
**caractérisée en ce que**
l'élément ressort élastique (7) est constitué d'une branche à parois minces s'écartant de l'élément d'accrochage.

8. Partie de boîtier selon l'une des revendications précédentes,
**caractérisée en ce que**
l'élément d'accrochage (2) est fabriqué d'une seule pièce en matière plastique, avec le crochet d'accrochage (4), la languette souple élastique (6), le bras ressort élastique (7) et au moins un tourillon (8).

9. Partie de boîtier selon la revendication 8,
**caractérisée en ce que**
la matière plastique est du polyoxyméthylène (POM).
